Europäisches Patentamt

European Patent Office

Office européen des brevets

(19)

(11) Publication number: **0 163 196 B1**

(12) **EUROPEAN PATENT SPECIFICATION**

(45) Date of publication of patent specification: **05.08.92**

(51) Int. Cl.⁵: **H03M 13/00, H04L 25/49**

(21) Application number: **85105920.4**

(22) Date of filing: **14.05.85**

(54) **Multi-state signal monitor circuit.**

(30) Priority: **01.06.84 JP 112658/84**

(43) Date of publication of application:
**04.12.85 Bulletin 85/49**

(45) Publication of the grant of the patent:
**05.08.92 Bulletin 92/32**

(84) Designated Contracting States:
**DE FR GB IT NL**

(56) References cited:
**FR-A- 2 535 136**
**GB-A- 2 072 997**
**GB-A- 2 122 457**
**US-A- 4 305 150**
**US-A- 4 449 222**

(73) Proprietor: **FUJITSU LIMITED**
**1015, Kamikodanaka Nakahara-ku**
**Kawasaki-shi Kanagawa 211(JP)**

(72) Inventor: **Nozue, Yoshihiro**
**3-15-204, Gokencho Nishinasunomachi**
**Nasu-gun Tochigi 329-27(JP)**

(74) Representative: **Lehn, Werner, Dipl.-Ing. et al**
**Hoffmann, Eitle & Partner Patentanwälte Ar-**
**abellastrasse 4**
**W-8000 München 81(DE)**

Rank Xerox (UK) Business Services

## Description

The present invention relates to multi-state-signal monitor circuit provided at the receiving side of a system for transmitting the data of plural bits by means of a multi-state signal.

Various systems have been proposed for transmitting data having plural bits after converting it into a multi-state signal. For example, in a digital radio transmission system utilizing quadrative amplitude modulation (QAM), the I-channel data and Q-channel data are respectively converted to multi-state signals. Two carriers having a phase difference of 90 degrees are respectively amplitude modulated and combined for transmission. The receiving signal is quadrature-detected by the carrier regenerated from said receiving signal and the I-channel and Q-channel multi-state signals thus obtained are converted to digital from analog form in order to obtain the original data.

In such a transmission system, if the radio link fails due to fading, etc., the error rate of received data becomes high and therefore if the error rate measured exceeds a specified value, the transmission line is switched to a spare transmission line or an equalizer is reset in order to prevent divergence of the equalizer.

As a method for measuring the error rate of received data, particular pattern is transmitted from the transmitting side and the accuracy of said pattern received is checked in the receiving side. However, this method has the following disadvantages:

a) Transmission capacity is reduced owing to transmission of said particular pattern.

b) A complicated circuit is required for detecting said particular pattern.

c) The error rate is usually small and therefore a longer time is taken for a cycle of measurement or a large time constant of integration is required for accurate measurement and thereby detection is much delayed.

As another method for measuring error rate of received data, a plurality of comparators for discriminating the quantization level and other levels and logic circuits for logically calculating outputs of such comparators are provided, a number of times of displacement from the quantization level at the time of discrimination of a received multi-state signal is measured as a speudo error rate and it is used as that corresponding to error rate. However, this method contains the following problem:

d) Many comparators are required and the logic circuits for calculating outputs from them are complicated as the number of bits of data to be transmitted increases and quantization levels increase.

As a further method for obtaining error rate of received data, analog to digital conversion is carried out at normal discrimination timing and at a timing a little shifted from the normal discrimination timing. The number of decisions for the value different from that of the normal discrimination timing is measured as a pseudo error rate and it is used as the value corresponding to the error rate. However, this method has the following disadvantages:

e) Another analog to digital converter is required for detection of the pseudo error rate, increasing the scale of the circuit.

f) Since the rate of deterioration of focusing degree to the quantization level due to the shift from the correct discrimination timing is different depending on the causes of line failure (for example, multi-path-fading by reflected wave, attenuation of signal by rain fall and device failure) accurate correspondence to error rate cannot be obtained.

US-A- 4 305 150 discloses an on-line channel monitor for measuring the quality of a communication channel of a transmission system wherein data is transmitted from the sending side after it is converted to a PSK signal and said data is regenerated through discrimination of said PSK signal in the receiving side. In the receiving side there is provided an analog-to-digital converter for discriminating the multi-state signal into a number of upper bits, which correspond to said data, and a plurality of lower bits, which serve for identifying the specified ranges separated from the quantization levels of said multi-state signal. Moreover it is provided a pseudo error rate measuring circuit for measuring the frequency of entering said specific ranges.

It is an object of the present invention to provide quick and an accurate error rate measurement in a QAM transmission system with multi-level amplitude modulation without reducing transmission capacity.

Briefly, an analog-to-digital converter for discriminating the received multi-state signal more precisely by a plurality of bits greater than the number of bits corresponding to the transmitted data and a pseudo error rate measuring circuit for reasuring the frequency of said plurality of bits to show the specified range separated from the quantization levels of said multi-state signal is provided in a transmission system being a QAM-system with multi-level amplitude modulation.

Fig. 1A and Fig. 1B show block diagrams of transmitting side and receiving side of a 16-value QAM-radio transmission system to which the present invention is applied;

Figs. 2A to Fig. 2C show waveforms of a 4-value signal in which the high frequency component is not limited, a 4-value signal in which the high frequency component is limited, and a clock signal;

Fig. 3A and Fig. 3B show profiles for explaining embodiments of the present invention; and

Figs.4A to Fig. 4G are block diagrams of embodiments of the present invention.

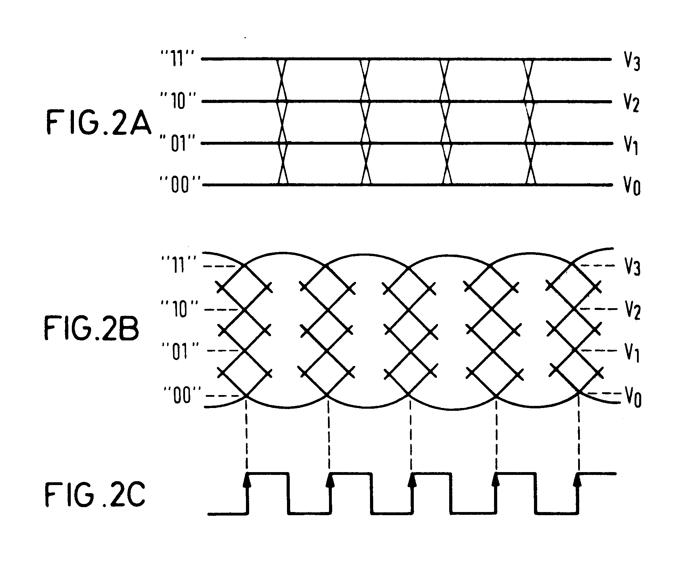

In transmitting side apparatus 10A of a 16-value QAM radio transmission system shown in Fig. 1A,

digital-to-analog converters 101, 102 respectively convert the 2-bit data DI, DQ of two systems of Inphase -channel (I-ch) and Quadrature-channel-(Q-ch) into the 4-value signals shown in Fig. 2A. In Fig. 2A, $V_0$ to $V_3$ show the quantization levels. The low-pass-filters 103 and 104 limit the high frequency component of said 4-value signals and shape the waveform as shown in Fig. 2B. Meanwhile, a 90° hybrid 105 branches the carrier output from an oscillator 106 into a couple of carriers having the phase difference of 90° and then outputs them to the mixers 107, 108, which respectively amplitude modulate said two carriers with a couple of said 4-value signals where the higher frequency components are limited. Said two modulated signals are combined in a hybrid 109 and then tramsitted from an antenna 111 via a transmitter 110.

In the receiving side apparatus 103 shown in Fig. 15, an incoming signal is received by a receiver 113 from an antenna 112. Said received signal is branched to the I-ch and Q-ch by a hybrid 114. Meanwhile, a 90° hybrid 115 branches two carriers having phase difference of 90° regenerated by the carrier regeneration circuit 116 and then outputs these signals to the mixers 117, 118 respectively, which respectively obtain the original 4-value signals by demodulating said I-ch and Q-ch received signal using said couple of regenerated carriers. Said demodulated couple of 4-value signals become similar to the modulated signal in the transmitting side shown in Fig. 2B when the line is normal. Even if the line fails, the signal is equalized by an equalizer 119 so long as such failure is minor and the signal is similar to that shown in Fig. 2B. As such carrier generation circuit and equalizer, those disclosed in the EP-A-0 129 514 are possible. The demodulated 4-valve signals of I-ch and Q-ch are respectively discriminated by the analog-to-digital converters 120 and 121. Thus , the I-ch is discriminated into the 4 bits ($b_0$ $b_3$), while Q-ch is discriminated into the 2 bits ($b_0,b_1$) respectively at the time instants where the clock shown in Fig. 2C rises. The respective upper two bits ($b_0,b_1$) are output as the discrimination data (D1,DQ) and the lower two bits ($b_2$, $b_3$) of I-ch are output to a pseudo error rate measuring circuit 122. The pseudo error rate measuring circuit 122 decides a pseudo error when the lower bits shows the range separated from the quantization levels

($V_0 \sim V_3$) and measures a frequency of such pseudo error as the pseudo error rate (err).

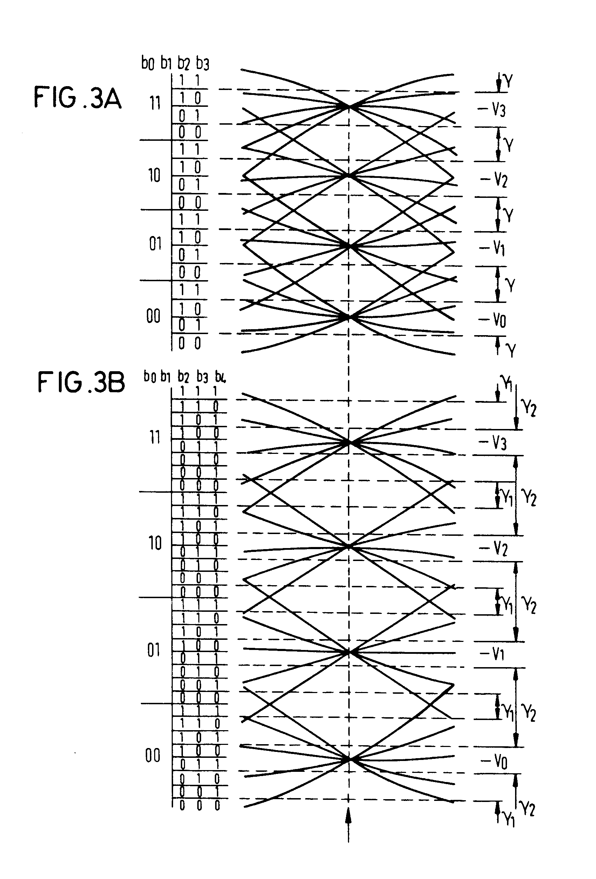

As shown in Fig. 3A, the range quantized or discrimited into the quantization levels ($V_0 \sim V_3$) is classified into four ranges by said lower bits ($b_2,b_3$). Of these ranges, the ranges indicated by the lower two bits ($b_2,b_3$) of "00" and "11" are separated from the quantization levels as shown by $\gamma$ in the Figure. The frequency of entering such range is considered as the pseudo error rate.

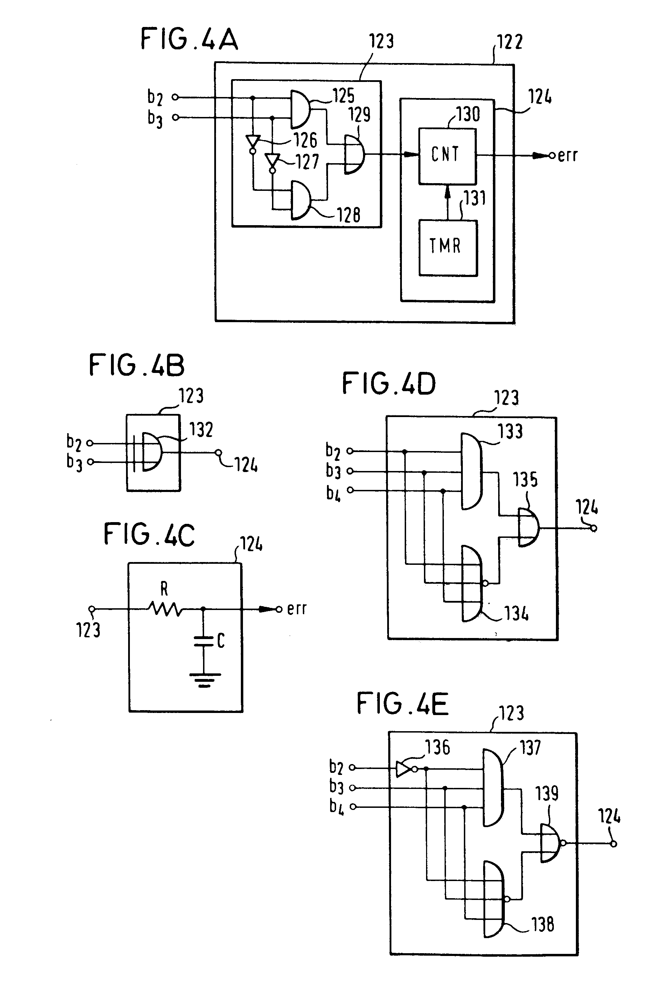

As shown in Fig. 4A, the pseudo error rate measuring circuit 122 is basically composed of a pseudo error detection circuit 123 which receives the lower 2 bits ($b_2,b_3$) of analog-to-digital converter 120 and detects pseudo errors and a measuring circuit 124 which receives the detected output sent from said pseudo error detection circuit 123 and measures the number

of such detections. The pseudo error detection circuit 123 is composed of an AND circuit 125 which ANDs said 2 bits ($b_2,b_3$), inverters 126 and 127 which respectively invert said 2 bits, an AND circuit 128 which ANDs the outputs of said inverters 126 and 127 and an OR circuit 129 which ORs the outputs of said AND circuits 125 and 128, and outputs "1" when said lower 2 bits are "00" or "11". The measuring circuit 124 is composed of a counter 130 which counts "1" output of the pseudo error detection circuit 123 and a timer which causes said counter 130 to output a value of said counter 130 for every constant period and also resets it, and outputs a value counting "1" within the constant period as the pseudo error rate. If the degree of convergence deteriorates due to line failure, the lower 2 bits of the analog-to-digital converter 120 more often become "00" or "11" and it is enough that the specified processing is carried out when said count value exceeds the predetermined value.

As shown in Fig. 4B, the pseudo error detection circuit 123 may be formed only by a single exclusive OR circuit 132. However, since it outputs "0" when said lower 2 bits ($b_2,b_3$) are "00" or "11", the counter 130 of measuring circuit 124 is required to count a number of times of the input to become "0"

As shown in Fig. 4C, the measuring circuit 124 may be formed by an integration circuit consisting of a resistor R and capacitor C and pseudo error rate may be output as an analog value. Where pseudo error detection is input at a high level, the difference between the integration output and a low level is determined as a pseudo error rate, where it is input at a low level, the difference between the integration output and a high level is determined as the pseudo error rate.

As shown in Fig. 3B, in case decision is made more minutely by 3 bits than the number of bits of data and said 3 bits ($b_2$, $b_3$, $b_4$) are used for pseudo error detection, it is possible to set the range as narrow as indicated by $\gamma_1$ or as wide as indicated by $\gamma_2$ as the range of pseudo error.

As shown in Fig. 4D, the pseudo error detection circuit which detects the range of $\gamma_1$ can be composed of an AND circuit 133 which ANDs said 3 bits ($b_2 \sim b_4$), a NOR circuit 134 which NORs said 3 bits and an OR circuit 135 which ORs outputs of the AND circuit 133 and NOR circuit 134. This circuit outputs "1" when said 3 bits are "000" or "111".

As shown in Fig. 4E, the pseudo error detection circuit which detects the range of $\gamma_2$ may be formed by an inverter 136 which inverts the most significant bit ($b_2$) of said 3 bits, an AND circuit 137 which ANDs the output of inverter 136 and two other bits ($b_3$, $b_4$), a NOR circuit which NORs the output of inverter 136 and two other bits and a NOR circuit 139 which NORs the output of AND circuit 137 and the output of NOR circuit 138. This detection circuit outputs "1" when said 3 bits are not "011" and "100".

When it is required to precisely set the range of pesudo error, further precise discrimination is necessary

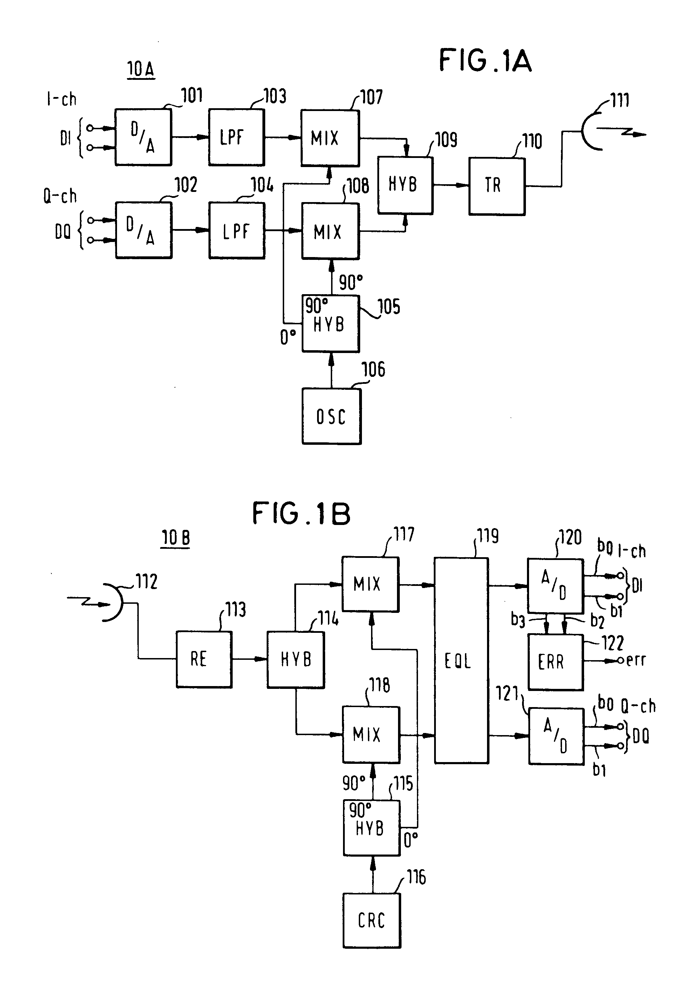

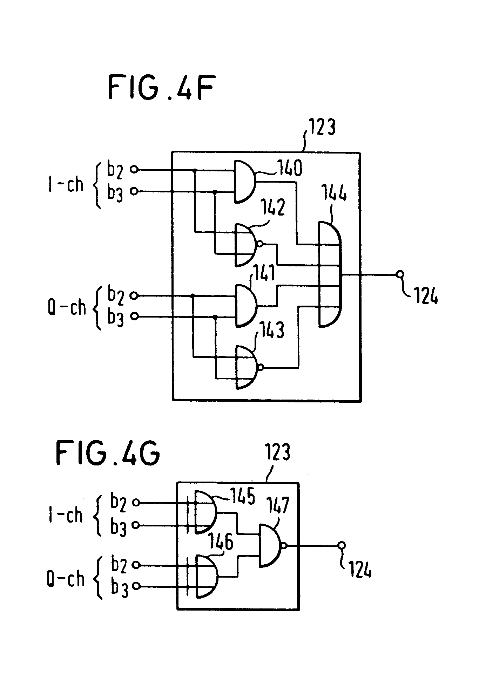

In Fig. 1B, only the I-ch signal is monitored but in case the Q-ch signal must be monitored,it can be achieved simply by providing the analog-to-digital converter and pseudo error rate measuring circuit which are the same as those for the I-ch also in the Q-ch. Where it is required to simultaneously monitor the I-ch and Q-ch, as shown in Fig. 4F, the pseudo error detection circuit 123 can be formed by the AND circuits 140 and 141 which ANDs 2 bits ($b_2$,$b_3$) for detecting pseudo errors of I-ch and Q-ch, the NOR circuits 142 and 143 which NOR respective 2 bits and an OR circuit 144 which ORs the outputs of said AND circuits 140 and 141 and the outputs of said NOR circuits 142 and 143. Similar logical operations may be realized by the circuit shown in Fig. 4G. The pseudo error detection circuit 123 shown in Fig. 4G is formed by the exclusive OR circuits 145 and 146 which each form the exclusive OR result of 2 bits of the I-ch and Q-ch and a NAND circuit 147 which NANDs the outputs of said exclusive OR circuit 145 and 146. This circuit outputs"1" when 2 bits of I-ch are "00" or "11" or when 2 bits of Q-ch are "00" or "11". This output is supplied to the measuring circuit 124.

In these embodiments, the present invention is applied to the 16-value QAM radio transmission system but it can also be adapted to any system where data is transmitted from the transmitting side after it is converted to a multi-value or state signal and said data is obtained in the receiving side by means of analog-to-digital conversion.

As explained above, the present invention descriminates the data more precisely than the number of bits of data by a plurality of bits in the receiving side and thereby detects a pseudo error only from said plurality of bits and thereby a pseudo error can be detected simply by using a simplified aditional circuit and the circuit is not complicated even when a number of bits of data increases. Moreover, an accurate error rate can be realized because data is monitored only at the decision timing of data. Where the range of pseudo error is set adequately, the frequency of generating pseudo errors can be set to the adequate degree and the pseudo error rate can be detected quickly. Moreover, the transmission capacity is not reduced because it is not required to transmit a particular pattern for the error rate detection.

## Claims

1. A multi-state signal monitor circuit for a transmission system wherein data is transmitted from the sending side after it is converted to a multi-state signal and said data is regenerated through discrimination of said multi-state signal in the receiving side, having, in the receiving side thereof, an analog-to-digital converter (120) for discriminating said multi-state signal into a number of upper bits, which correspond to said data, and a plurality of lower bits, which serve for identifying specified ranges separated from the quantization levels of said multi-state signal, and

   a pseudo error rate measuring circuit (122) for measuring the frequency of entering said specified ranges as a pseudo error rate,

   **characterized** by

   said transmission system being a QAM-system with a multi-level amplitude level modulation.

2. A multi-state signal monitor circuit according to claim 1, wherein said pseudo error rate measuring circuit (122) comprises

   a pseudo error detection circuit (123) for detecting whenever said plurality of lower bits indicate said specified range, and

   a measuring circuit (124) for measuring frequency of detection in said pseudo error detection circuit (123).

3. A multi-state signal monitor circuit according to claim 2, wherein said pseudo error detection circuit (123) comprises:

a first AND circuit (125) for obtaining the AND result of said plurality of bits;

a plurality of inverters (126, 127) which invert said plurality of bits,

a second AND circuit (128) for obtaining the AND result of the outputs of said plurality of inverters (126, 127), and

an OR circuit (129) for obtaining the OR result of the outputs of said first and second AND circuits (125, 128).

4. A multi-state signal monitor circuit according to claim 2, wherein said pseudo error detection circuit (123) comprises:

an AND circuit (133) for obtaining the AND result of said plurality of bits,

a NOR circuit (134) for obtaining the NOR result of said plurality of bits, and

an OR circuit (124) for obtaining the OR result of the output of said AND circuit (133) and the output of said NOR circuit (134).

5. A multi-state signal monitor circuit according to claim 2, wherein said pseudo error detection circuit comprises:

an inverter (136) for inverting the most significant bit among said plurality of bits,

an AND circuit (137) for obtaining the AND result of the bits except for the most significant bit among said plurality of bits and the output of said inverer (136);

a NOR circuit (138) for obtaining the NOR result of the bits except for the most significant bit among said plurality of bits and the output of said inverer (136), and

a second NOR circuit (139) for obtaining the NOR result of the output of said AND circuit (137) and the output of said first NOR circuit (138).

6. A multi-state signal monitor circuit according to claim 2, wherein said plurality bits are 2 bits and said pseudo error detection circuit comprises an exclusive OR circuit (132) for obtaining the exclusive OR result of said 2 bits.

7. A multi-state signal monitor circuit according to claim 2, wherein said pseudo error detection circuit (123) comprises,

first and second AND circuits (140, 141) for obtaining the AND result of respective pluralities of bits of the I and Q channels,

first and second NOR circuits (142, 143) for obtaining a NOR result of respective plurality of bits of said two channels, and

an OR circuit (144) for obtaining an OR result of the outputs of said first and second AND circuits (140, 141) and the outputs of said first and second NOR circuits (142, 143).

8. A multi-state signal monitor circuit according to claim 2, wherein said plurality of bits includes 2 bits, and said pseudo error detection circuit (123) comprises,

the first and second exclusive OR circuits (145, 146) for obtaining an exclusive OR result of said 2 bits of the I and Q channels, and

a NAND circuit (147) for obtaining a NAND result of the outputs of said exclusive OR circuit.

9. A multi-state signal monitor circuit according to any one of claims 2 to 8, wherein said measuring circuit (124) comprises,

a counter (130) for counting "1" or "0" of said detection circuit (123) and

a timer (131) for causing said counter (130) to output a counted value for every constant period and also for resetting said counter (130).

10. A multi-state signal monitor circuit according to any one of claims 2 to 8, wherein said measuring circuit (124) comprises an integration circuit (R, C) for integrating the output of said detection circuit (124).

**Revendications**

1. Circuit de contrôle de signal à états multiples pour un système de transmission dans lequel les données sont transmises du côté d'émission après leur conversion en un signal à états multiples, et où lesdites données sont regénérées par discrimination du dit signal à états multiples du côté de réception, comportant, de son côté de réception, un convertisseur analogique- numérique (120) pour discriminer ledit signal à états multiples en un nombre de bits supérieurs qui correspond aux dites données, et en une pluralité de bits inférieurs qui servent à identifier des dynamiques spécifiées séparées des niveaux de quantification du dit signal à états multiples, et

un circuit de mesure (122) du taux de pseudo- erreurs, pour mesurer la fréquence d'entrée des dites dynamiques spécifiées comme taux de pseudo- erreurs,

caractérisé en ce que,

ledit système est un système QAM à modulation d'amplitude à niveaux multiples.

2. Circuit de contrôle de signal à états multiples selon la revendication 1, dans lequel ledit circuit de mesure (122) du taux de pseudo- erreurs comporte :

un circuit de détection (123) de pseudo-erreurs pour détecter si ladite pluralité des bits inférieurs indique ladite dynamique spécifiée, et

un circuit de mesure (124) pour mesurer la fréquence de détection dans ledit circuit de détection (123) de pseudo-erreurs.

3. Circuit de contrôle de signal à états multiples selon la revendication 2, dans lequel ledit circuit de détection (123) de pseudo- erreurs comporte :

un premier circuit ET (125) pour obtenir le résultat de combinaison en ET logique de ladite pluralité de bits ;

une pluralité d'inverseurs (126, 127) qui inversent ladite pluralité de bits,

un second circuit ET (128) pour obtenir le résultat en ET logique des sorties de ladite pluralité d'inverseurs (126, 127) et,

un circuit OU (129) pour obtenir le résultat en OU logique des sorties des dits premier et second circuits ET (125, 128).

4. Circuit de contrôle de signal à états multiples selon la revendication 2, dans lequel ledit circuit de détection (123) de pseudo- erreurs comporte :

un premier circuit ET (133) pour obtenir le résultat de combinaisons en ET logique de ladite pluralité de bits,

un circuit NON OU (134) pour obtenir le résultat en NON OU logique de ladite pluralité des bits, et

un circuit OU (124) pour obtenir le résultat en OU logique de la sortie du dit circuit ET (133) et de la sortie de ladite porte NON OU (134).

5. Circuit de contrôle de signal à états multiples selon la revendication 2, dans lequel ledit circuit de détection de pseudo- erreurs comporte :

un inverseur (136) pour inverser le bit le plus significatif dans ladite pluralité des bits,

une porte ET (137) pour obtenir le résultat en ET logique des bits sauf le bit le plus significatif parmi ladite pluralité des bits et la sortie du dit inverseur (136) ;

un circuit NON OU (138) pour obtenir le résultat en NON OU logique des bits, sauf le bit le plus significatif parmi ladite pluralité des bits et la sortie du dit inverseur (136), et

un circuit NON OU (138) pour obtenir le résultat en NON OU logique des bits, sauf le bit le plus significatif parmi ladite pluralité des bits et la sortie du dit inverseur (136), et

un second circuit NON OU (139) pour obtenir le résultat en NON OU logique de la sortie du dit circuit ET (139) et de la sortie de ladite porte NON OU (138).

6. Circuit de contrôle de signal à états multiples selon la revendication 2, dans lequel ladite pluralité de bits est réduite à deux bits et/ ou ledit circuit de détection de pseudo- erreurs comporte un circuit OU exclusif (132) pour obtenir le résultat en OU exclusif logique des dits deux bits.

7. Circuit de contrôle de signal à états multiples selon la revendication 2, dans lequel ledit circuit (123) de détection de pseudo- erreurs comporte :

des premier et second circuits ET (140, 141) pour obtenir le résultat en ET des pluralités respectives de bits des canaux I et Q,

des premier et second circuits NON OU (142, 143) pour obtenir le résultat en NON OU logique des pluralités respectives de bits des dits deux canaux, et

un circuit OU (144) pour obtenir un résultat en OU logique des sorties des dits premier et second circuit ET (140, 141) et des sorties des dits premier et second circuits NON OU (142, 143).

8. Circuit de contrôle de signal à états multiples selon la revendication 2, dans lequel ladite pluralité de bits comporte deux bits et dans laquelle ledit circuit de détection (123) de détection de pseudo- erreurs comporte :

des premier et second circuits en OU exclusif (145, 146) pour obtenir le résultat en OU exclusif logique des dits deux bits des canaux I et Q, et

un circuit NON ET (147) pour obtenir un résultat en NON ET logique des sorties des dits circuits OU exclusif.

9. Circuit de contrôle de signal à états multiples selon l'une quelconque des revendications 2 à 8, dans lequel ledit circuit de mesure (124) comporte:

un compteur (130) pour compter les "1" ou les "0" du dit circuit de détection (123), et

une horloge (131) pour provoquer la sortie par ledit compteur (130) d'une valeur de comptage à chaque période constante et aussi pour remettre à jour ledit compteur (130).

10. Circuit de contrôle de signal à états multiples selon l'une quelconque des revendications 2 à 8, dans lequel ledit circuit de mesure (124) comporte:

un circuit d'intégration R, C pour intégrer la sortie du dit circuit de détection (124).

**Patentansprüche**

1. Mehrpegelsignal-Kontrollschaltung für ein Übertragungssystem, in welchem Daten von der Sendeseite übertragen werden, nachdem sie in ein Mehrpegelsignal umgewandelt wurden, und die Daten durch Diskriminierung des Mehrpegelsignals an der Empfangsseite wiedergewonnen werden, mit - in der Empfangsseite - einem Analog/Digital-Wandler (120) zur Diskriminierung des Mehrpegelsignals in eine Anzahl oberer Bits, die den Daten entsprechen, und mehrere untere Bits, die zur Identifizierung festgelegter Bereiche dienen, die von den Quantisierungspegeln des Pegelsignals getrennt sind, und

einer Pseudo-Fehlerraten-Meßschaltung (122) zur Messung der Frequenz des Eintritts in die festgelegten Bereiche als eine Pseudo-Fehlerrate,

dadurch gekennzeichnet, daß das Übertragungssystem ein QAM-System mit einer Mehrpegel-Amplitudenpegelmodulation ist.

2. Mehrpegelsignal-Kontrollschaltung nach Anspruch 1, bei welcher die Pseudo-Fehlerraten-Meßschaltung (122)

eine Pseudo-Fehler-Ermittlungsschaltung (123) aufweist, um zu ermitteln, wann jeweils die mehreren unteren Bits den festgelegten Bereich anzeigen, und

eine Meßschaltung (124) aufweist, um die Nachweisfrequenz in der Pseudo-Fehler-Ermittlungsschaltung (123) zu messen.

3. Mehrpegelsignal-Kontrollschaltung nach Anspruch 2, bei welcher die Pseudo-Fehler-Ermittlungsschaltung (123)

eine erste AND-Schaltung (125) aufweist, um das AND-Ergebnis der mehreren Bits zu erhalten;

mehrere Invertierer (126, 127), welche die mehreren Bits invertieren,

eine zweite AND-Schaltung (128), um das AND-Ergebnis der Ausgangssignale der mehreren Invertierer (126, 127) zu erhalten, und

eine OR-Schaltung (129), um das OR-Ergebnis der Ausgangssignale der ersten und zweiten AND-Schaltung (125, 128) zu erhalten.

4. Mehrpegelsignal-Kontrollschaltung nach Anspruch 2, bei welcher die Pseudo-Fehler-Ermittlungsschaltung (123)

eine AND-Schaltung (133) aufweist, um das AND-Ergebnis der mehreren Bits zu erhalten,

eine NOR-Schaltung (134), um das NOR-Ergebnis der mehreren Bits zu erhalten, und

eine OR-Schaltung (124), um das OR-Ergebnis des Ausgangssignals der AND-Schaltung (133) und des Ausgangssignals der NOR-Schaltung (134) zu erhalten.

5. Mehrpegelsignal-Kontrollschaltung nach Anspruch 2, bei welcher die pseudo-Fehler-Ermittlungsschaltung

einen Invertierer (136) aufweist, um das höchstwertige Bit unter den mehreren Bits zu invertieren,

eine AND-Schaltung (137), um das AND-Ergebnis der Bits, abgesehen von dem höchstwertigen Bit unter den mehreren Bits, und des Ausgangssignals des Invertierers (136) zu erhalten;

eine NOR-Schaltung (138), um das NOR-Ergebnis der Bits, abgesehen von dem höchstwertigen Bit unter den mehreren Bits, und des Ausgangssignals des Invertierers (136) zu erhalten, und

eine zweite NOR-Schaltung (139), um das NOR-Ergebnis des Ausgangssignals der AND-Schaltung (137) und des Ausgangssignals (137) der ersten NOR-Schaltung (138) zu erhalten.

**6.** Mehrpegelsignal-Kontrollschaltung nach Anspruch 2, bei welcher die mehreren Bits 2 Bits sind, und die Pseudo-Fehler-Ermittlungsschaltung eine exklusive ODER-Schaltung (132) aufweist, um das exklusive ODER-Ergebnis der 2 Bit zu erhalten.

**7.** Mehrpegelsignal-Kontrollschaltung nach Anspruch 2, bei welcher die pseudo-Fehler-Ermittlungsschaltung (123)

eine erste und eine zweite AND-Schaltung (140, 141) aufweist, um das AND-Ergebnis jeweils mehrerer Bits des I- und des Q-Kanals zu erhalten,

eine erste und zweite NOR-Schaltung (142, 143), um ein NOR-Ergebnis der jeweils mehreren Bits der beiden Kanäle zu erhalten, und

eine OR-Schaltung (144), um ein OR-Ergebnis der Ausgangssignale der ersten und zweiten AND-Schaltungen (140, 141) und der Ausgangssignale der ersten und zweiten NOR-Schaltungen (142, 143) zu erhalten.

**8.** Mehrpegelsignal-Kontrollschaltung nach Anspruch 2, bei welcher die mehreren Bits 2 Bits aufweisen, und die Pseudo-Fehler-Ermittlungsschaltung (123)

die erste und zweite exklusive OR-Schaltungen (145, 146), aufweist, um ein exklusives ODER-Ergebnis der 2 Bits des I- und Q-Kanals zu erhalten, und

eine NAND-Schaltung (147), um ein NAND-Ergebnis der Ausgangssignale der exklusiven ODER-Schaltungen zu erhalten.

**9.** Mehrpegelsignal-Kontrollschaltung nach einem der Ansprüche 2 bis 8, bei welcher die Meßschaltung (124)

einen Zähler (130) aufweist, um "1" oder "0" der Nachweisschaltung (123) zu zählen, und

einen Zeitgeber (131), um den Zähler (130) dazu zu veranlassen, einen gezählten Wert für jede konstante Periode auszugeben, und um den Zähler (130) zurückzusetzen.

**10.** Mehrpegelsignal-Kontrollschaltung nach einem der Ansprüche 2 bis 8, bei welcher die Meßschaltung (124) eine Integrierschaltung (R, C) aufweist, um das Ausgangssignal der Ermittlungsschaltung (124) zu integrieren.

FIG.1A

10 A

FIG.1B

10 B

FIG.2A

FIG.2B

FIG.2C

FIG.3A

FIG.3B

# FIG.4A

b₂
b₃

125
129
126
127
128
123

130
CNT
131
TMR
124
122

o err

# FIG.4B

123
b₂
b₃
132
124

# FIG.4D

123
b₂
b₃
b₄
133
135
134
124

# FIG.4C

124
R
123
C
o err

# FIG.4E

123
b₂
b₃
b₄
136
137
139
138
124

12

# FIG.4F

# FIG.4G